# FASCICULE DE BREVET EUROPEEN

(11) **EP 1 846 344 B1**
(45) Date de publication et mention de la délivrance du brevet: **02.05.2012**
(21) Numéro de dépôt: 06709450.8
(22) Date de dépôt: 27.01.2006
(51) Int. Cl.: C04B 35/624

(54) **PROCEDE DE PREPARATION DE CERAMIQUES OXYDES A BASE DE PLOMB, DE TITANE, DE ZIRCONIUM ET DE LANTHANIDE(S)**
VERFAHREN ZUR HERSTELLUNG VON OXIDKERAMIK AUF BASIS VON BLEI, TITAN, ZIRCONIUM UND LANTHANID(EN)
METHOD OF PREPARING OXIDE CERAMIC BASED ON LEAD, TITANIUM, ZIRCONIUM AND LANTHANIDE(S)

(30) Priorité: 27.01.2005 FR 0550234
(43) Date de publication de la demande: 24.10.2007
(73) Titulaire: Commissariat à l'Énergie Atomique et aux Énergies Alternatives, 75015 Paris (FR)
(72) Inventeur: BELLEVILLE, Philippe, F-37000 Tours (FR); BOY, Philippe, F-37300 Joue Les Tours (FR); MONTOUILLOUT, Yves, F-45130 Le Bardon (FR)
(74) Mandataire: Poulin, Gérard
(86) Numéro de dépôt international: PCT/FR2006/050066
(87) Numéro de publication internationale: WO 2006/079757

(56) Documents cités:
- EP-A- 0 486 686
- KURCHANIA R ET AL: "SYNTHESIS OF (PB,LA) (ZR,TI)O3 FILMS USING A DIOL BASED SOL-GEL ROUTE" JOURNAL OF MATERIALS SCIENCE, SPRINGER / BUSINESS MEDIA, DORDRECHT, NL, vol. 33, no. 3, 1 février 1998 (1998-02-01), pages 659-667, XP000733018 ISSN: 0022-2461 cité dans la demande
- CHOI H-W ET AL: "ELECTRICAL AND OPTICAL PORPERTIES OF PLZT THIN FILMS ON ITO COATED GLASS BY SOL-GEL PROCESSING" JOURNAL OF MATERIALS SCIENCE, CHAPMAN AND HALL LTD. LONDON, GB, vol. 35, no. 6, 15 mars 2000 (2000-03-15), pages 1475-1479, XP001004929 ISSN: 0022-2461

## Description

### DOMAINE TECHNIQUE

La présente invention a pour objet un procédé de préparation d'une solution sol-gel stable précurseur d'une céramique oxyde à base de plomb, de titane, de zirconium et d'un métal lanthanide.

L'invention concerne aussi la solution sol-gel susceptible d'être obtenue par ce procédé.

La présente invention a également pour objet un procédé de préparation d'un matériau en céramique oxyde à base de plomb, de titane, de zirconium et d'un métal lanthanide à partir d'une telle solution sol-gel stable.

Enfin, l'invention concerne un matériau susceptible d'être obtenu par ce procédé.

De tels matériaux ont la particularité de présenter une forte constante diélectrique, ainsi que des propriétés piézoélectriques et ferroélectriques et se révèlent donc particulièrement efficaces dans de nombreuses applications électroniques, telles que les actuateurs, les capteurs, les mémoires non-volatiles et les capacités.

### ÉTAT DE LA TECHNIQUE ANTÉRIEURE

Ce type de céramiques peut être obtenu par des procédés en phase vapeur, en phase plasma, en phase solide ou encore en phase liquide.

Pour les procédés se déroulant en phase vapeur, le procédé le plus communément utilisé est l'évaporation, dans laquelle la céramique à déposer est placée dans un creuset porté à une température telle que des vapeurs se forment et se recondensent sous forme d'un revêtement ou couche sur un substrat refroidi. On peut citer également les procédés de synthèse de céramique par dépôt chimique en phase vapeur (communément désigné par l'abréviation CVD).

Pour les procédés mettant en jeu une phase plasma, on peut citer la pulvérisation cathodique. Selon cette technique, le matériau céramique à déposer est bombardé par des ions générés par un plasma. L'énergie cinétique des ions du plasma est transférée aux atomes du matériau à déposer qui sont projetés à grande vitesse sur le substrat à revêtir et se déposent sur celui-ci sous forme d'un revêtement ou couche. L'inconvénient de ces procédés se déroulant en phase plasma réside dans le fait qu'ils sont très coûteux.

Pour les procédés se déroulant en phase solide, on peut citer le frittage de composés organométalliques suivi d'un recuit.

On peut citer encore une technique mettant en oeuvre une dispersion solide/liquide consistant à mélanger une poudre céramique à un solvant organique, à déposer cette dispersion sous forme de couche sur un substrat et à traiter thermiquement cette couche. Une autre technique consiste à fritter une poudre céramique sur un substrat avec ajout de colle. Pour ces deux techniques, l'épaisseur des couches ne peut être contrôlée précisément.

Les procédés en phase solide nécessitent la mise en oeuvre de températures très élevées (généralement supérieures à 1000°C) et la mise en place d'un appareillage réfractaire.

Une voie permettant de contourner les inconvénients des procédés évoqués ci-dessus est une voie se déroulant uniquement en phase liquide, qui n'est autre que le procédé sol-gel.

Le procédé sol-gel consiste, dans un premier temps, à préparer une solution contenant des précurseurs de ces céramiques oxydes à l'état moléculaire (composés organométalliques, sels métalliques, lesquels comprennent les éléments métalliques, qui seront incorporés dans la céramique), formant ainsi un sol (également appelé solution sol-gel). Dans un deuxième temps, cette solution sol-gel est déposée, sous forme d'un film, sur un substrat. Au contact de l'humidité ambiante, les précurseurs s'hydrolysent et se condensent pour former un réseau d'oxyde emprisonnant le solvant, ce qui aboutit à un gel. La couche de gel formant un film est ensuite traitée thermiquement de façon à former un film en céramique.

Le procédé sol-gel présentent de nombreux avantages par rapport aux procédés explicités plus haut :
- il permet de réaliser des revêtements sur des surfaces complexes de tailles diverses et sans nécessiter d'équipement lourd ;
- il permet d'obtenir des dépôts homogènes en surface, composition et épaisseur ;
- du fait que le mélange des espèces se déroule à l'échelle moléculaire, il est possible de réaliser facilement par ce procédé des oxydes complexes comportant, par exemple, trois éléments ou plus.

De ce fait, le procédé sol-gel pour la préparation de céramique oxyde à base de métal lanthanide, de plomb, de titane et de zirconium a fait l'objet de nombreuses publications dans l'art antérieur.

Ainsi, Simoes et al. dans Thin Solid Films 384 (2001) 132-137 [1] décrivent un procédé de préparation d'une solution sol-gel précurseur d'une telle céramique par dissolution de précurseurs moléculaires des éléments métalliques la constituant (respectivement, n-propoxyde de zirconium, isopropoxyde de titane, carbonate de lanthane, et acétate de plomb) dans de l'éthylène glycol et de l'acide citrique. A l'issue de la dissolution, les auteurs procèdent à un ajout d'eau dans la solution, afin d'ajuster la viscosité. L'inconvénient majeur de ce procédé réside dans l'utilisation d'eau, qui contribue à rendre la solution peu stable et qui impose une utilisation quasi instantanée de la solution après préparation.

Es-Souni et al dans Thin Solid Films 389 (2001) 99-107 [2] décrivent un procédé de préparation d'une solution sol-gel précurseur d'une céramique à base de lanthane, plomb, titane et zirconium comprenant la dissolution de précurseurs moléculaires (respectivement, acétate de plomb, nitrate de lanthane, tétrapropylzirconate, tétraisopropylorthotitanate) dans du méthoxyéthanol suivie de l'addition d'acétylacétone et d'acide acétique à la solution obtenue précédemment. Ce procédé présente l'inconvénient d'utiliser comme solvant de dissolution le méthoxyéthanol, qui est un solvant hautement toxique et prohibé industriellement, ce qui exclut les solutions obtenues selon ce procédé d'une possible exploitation industrielle et commerciale. De plus, les solutions obtenues selon ce procédé ne présentent pas une stabilité à long terme, à savoir une viscosité qui reste stable pendant une durée d'au moins 1 année.

La demande de brevet EP 0 564 866 [3] décrit un procédé de préparation de solutions sol-gel précurseurs d'une telle céramique oxyde par solubilisation des précurseurs moléculaires appropriés dans du méthoxyéthanol. Ce procédé, pour les raisons mentionnées ci-dessus, ne peut être utilisé à l'échelle industrielle.

Kurchania et al. dans Journal of Materials Science 33 (1998) 659-667 [4] décrivent la préparation d'une solution sol-gel telle que définie ci-dessus comprenant les étapes suivantes :
- une étape de préparation d'une première solution par dissolution d'acétate de plomb et d'acétate de lanthane dans du 1,3-propanediol ;
- une étape de préparation d'une seconde solution par mélange d'une solution de n-propoxyde de zirconium dans de l'acétylacétone et d'une solution de diisopropoxyde bisacétylacétonate de titane dans du 1,3-propanediol ;
- une étape de mélange de la première solution et de la deuxième solution, suivie d'une étape de dilution du mélange obtenu par du propanol.

Il est décrit que la solution sol-gel obtenue à l'issue de ce procédé est stable pendant une durée maximale de 4 mois. Toutefois, cette durée est insuffisante en vue d'une exploitation commerciale de ces solutions.

Enfin, les brevets américains US 5,028,455 [5] et US 5,116,643 [6] décrivent la préparation de solutions sol-gel consistant à dissoudre les précurseurs de lanthane, de plomb, de titane et de zirconium dans des solvants différents puis après mélange des différentes solutions préparées, à ajouter de l'eau au mélange résultant. Toutefois, l'inconvénient de ces procédés est l'utilisation d'eau qui contribue à rendre les solutions sol-gel résultantes instables à court terme, c'est-à-dire au bout de quelques semaines.

WO 03/024871 décrit un procédé de préparation d'un film à partir d'une solution sol-gel PZT par un traitement thermique classique.

Ainsi, les procédés de l'art antérieur présentent tous l'un ou plusieurs des inconvénients suivants :
- ils mettent en oeuvre des solvants toxiques, qui ne peuvent être utilisés dans l'industrie ;
- ils engendrent des solutions sol-gel, qui ne sont pas stables à long terme, à savoir sur une durée d'un an ou plus.

L'invention a donc pour but, entre autres, de surmonter les inconvénients de l'art antérieur cité plus haut et de fournir un procédé de préparation d'une solution sol-gel stable précurseur d'une céramique oxyde à base de plomb, de titane, de zirconium et d'un métal lanthanide.

Par solution sol-gel stable, l'on entend au sens de l'invention, une solution dont la viscosité reste sensiblement la même, notamment après 1 an de vieillissement voire une durée plus importante.

Le but de l'invention est encore de fournir un procédé de préparation de matériaux en céramique oxyde à partir de ladite solution sol-gel, qui soit entre autres, répétable et reproductible et d'une durée réduite, afin d'être applicable à une échelle industrielle.

Ce procédé doit permettre notamment l'obtention de matériaux présentant des constantes diélectriques élevées de l'ordre de 800-950 pour de très faibles épaisseurs de films de l'ordre de 150 à 220 nm.

Par répétabilité, on entend, selon l'invention, un procédé de préparation de matériaux, dont les propriétés électriques, entre autres, ne varient pas, lorsque lesdits matériaux sont préparés à partir d'une même solution sol-gel, à différents stades de vieillissement de ladite solution.

Par reproductibilité, on entend, selon l'invention, un procédé de préparation de matériaux, dont les propriétés électriques, entre autres, ne varient pas, lorsque lesdits matériaux sont préparés à partir de différentes solutions sol-gel, réalisées en respectant les mêmes conditions opératoires.

### EXPOSÉ DE L'INVENTION

Ces buts sont atteints, conformément à l'invention, par un procédé de préparation d'une solution sol-gel stable précurseur d'une céramique oxyde à base de plomb, de titane, de zirconium et d'un métal lanthanide comprenant successivement les étapes suivantes :
a) préparer une solution sol-gel, par mise en contact d'un précurseur moléculaire de plomb, d'un précurseur moléculaire de titane, d'un précurseur moléculaire de zirconium et d'un précurseur moléculaire du métal lanthanide avec un milieu comprenant un solvant diol et éventuellement un monoalcool aliphatique ;
b) mettre au repos la solution obtenue en a) pendant un temps suffisant nécessaire à l'obtention d'une solution présentant une viscosité sensiblement constante ;
c) diluer à un taux prédéterminé la solution obtenue en b) avec un solvant diol identique à celui de l'étape a) ou un solvant miscible avec le solvant diol utilisé dans l'étape a).

Selon l'invention, par solvant miscible, on entend, un solvant qui peut se mélanger au solvant diol en formant un mélange homogène, et ceci en toutes proportions à température ambiante, c'est-à-dire à une température de l'atmosphère environnante, généralement comprise entre 20 et 25°C.

Le procédé de l'invention permet avantageusement d'obtenir une solution sol-gel stable, et ce grâce aux caractéristiques suivantes :
- il met en oeuvre un solvant diol, qui, outre le rôle d'agent solubilisant des précurseurs moléculaires, assure également un rôle d'agent stabilisant de la solution obtenue ;
- il met en oeuvre une étape dite de mûrissement (étape b) qui contribue à la stabilisation de la solution sol-gel ;
- l'étape finale de dilution permet, en sus de son rôle d'ajuster la viscosité de la solution sol-gel, de figer la valeur de viscosité de ladite solution et contribue ainsi à la formation d'une solution sol-gel présentant une stabilité à très long terme (de l'ordre d'un an voire plus).

Ainsi, le procédé de l'invention comprend, dans un premier temps, la préparation d'une solution sol-gel, par mise en contact d'un précurseur moléculaire de plomb, d'un précurseur moléculaire de titane, d'un précurseur moléculaire de zirconium et d'un précurseur moléculaire du métal lanthanide avec un milieu organique comprenant un solvant diol et éventuellement un monoalcool aliphatique.

Le précurseur moléculaire de plomb peut être choisi parmi les sels inorganiques de plomb, les composés organométalliques de plomb. A titre d'exemples de sels inorganiques de plomb, on peut citer le cholure de plomb, le nitrate de plomb. A titre d'exemples de composés organométalliques de plomb, on peut citer l'acétate de plomb, les alcoxydes de plomb.

Le précurseur moléculaire de métal lanthanide peut être un précurseur moléculaire de lanthane, lequel peut se présenter sous forme d'un composé organométallique de lanthane, tel que l'acétate de lanthane, ou un sel inorganique de lanthane, tel que le nitrate de lanthane, le chlorure de lanthane.

Enfin, les précurseurs moléculaires de titane et de zirconium peuvent être respectivement des sels inorganiques de titane et des sels inorganiques de zirconium ou encore des composés orgométalliques de titane ou de zirconium, tels que des alcoxydes comme l'isopropoxyde de titane et le n-propoxyde de zirconium.

Les précurseurs tels que mentionnés ci-dessus sont mis en contact avec un milieu comprenant un solvant diol et éventuellement un monoalcool aliphatique.

Le solvant diol utilisé dans l'étape a) et éventuellement c) peut être un alkylène glycol, ayant un nombre d'atomes de carbone allant de 2 à 5. Ce type de solvant contribue à faciliter la solubilisation des précurseurs et, de plus, joue un rôle d'agent stabilisant de la solution sol-gel. De préférence, le solvant diol utilisé est l'éthylène glycol.

En complément du solvant diol, le milieu peut comprendre également un monoalcool aliphatique, pouvant, par exemple, comprendre de 1 à 6 atomes de carbone. A titre d'exemple de monoalcool aliphatique, on peut citer le n-propanol.

Selon l'invention, le métal lanthanide peut être choisi parmi La, Ce, Pr, Nd, Pm, Sm, Eu, Gd, Tb, Dy, Ho, Er, Tm, Yb, Lu. De préférence, le métal lanthanide est le lanthane.

Ainsi, le procédé de l'invention est particulièrement adapté à la préparation de solutions sol-gel précurseurs de céramiques oxyde répondant à la formule suivante :

Pb_{1-y}La_{y}(Zr₁₋ₓTiₓ)O₃

dans laquelle 0<y≤0,2 et 0<x≤0,9

La manière de mettre en contact les précurseurs définis ci-dessus avec un milieu tel que défini ci-dessus peut se faire de plusieurs façons, l'essentiel étant d'obtenir à l'issue de cette étape une solution sol-gel, dans laquelle les précurseurs moléculaires de plomb, de titane, de zirconium et de métal lanthanide sont solubilisés dans le milieu.

Selon un mode particulier de réalisation de l'invention, lorsque le métal lanthanide est du lanthane, l'étape a) comprend :
- la préparation d'une première solution par dissolution, dans un milieu organique comprenant un solvant diol, tel que l'éthylène glycol, d'un précurseur moléculaire de plomb et d'un précurseur moléculaire de lanthane ;
- la préparation d'une deuxième solution par dissolution d'un précurseur moléculaire de titane et d'un précurseur moléculaire de zirconium dans un milieu organique comprenant un monoalcool aliphatique, tel que le n-propanol, et éventuellement un solvant diol identique à celui utilisé dans la précédente étape ;
- le mélange de ladite première solution et de ladite seconde solution, éventuellement en chauffant à reflux.

Plus précisément, selon ce mode particulier de réalisation, la première solution est préparée par dissolution dans un milieu comprenant un solvant diol (tel que l'éthylène glycol) d'un précurseur de plomb et d'un précurseur moléculaire de lanthane, de préférence en chauffant l'ensemble pour faciliter la dissolution. Les précurseurs moléculaires, notamment le précurseur moléculaire de plomb, peuvent exister sous forme hydratée, auquel cas le chauffage peut servir à distiller l'eau libérée dans le mélange réactionnel lors de la dissolution des précurseurs susmentionnés. C'est le cas notamment, lorsque le précurseur moléculaire de plomb utilisé est l'acétate de plomb trihydraté.

Parallèlement, selon ce mode de réalisation, l'on prépare une deuxième solution par dissolution d'un précurseur moléculaire de titane et d'un précurseur moléculaire de zirconium dans un milieu organique comprenant un monoalcool aliphatique, tel que le n-propanol, et éventuellement un solvant diol tel que celui utilisé pour la préparation de la première solution.

Ensuite, la première solution et la deuxième solution préparée séparément sont mélangées, de façon à obtenir une seule solution sol-gel homogène. De préférence, cette étape de mélange est facilitée par un chauffage à reflux. Une fois que la solution présente un aspect homogène, le chauffage est arrêté et la solution est ramenée à la température ambiante.

Ce mode de réalisation est particulièrement adapté lorsque les précurseurs moléculaires sont respectivement l'acétate de plomb trihydraté, l'acétate de lanthane, l'isopropoxyde de titane et le n-propoxyde de zirconium.

Une fois la solution sol-gel obtenue à l'issue de l'étape a), que ce soit par le mode de réalisation décrit ci-dessus ou encore par un autre mode de réalisation, la solution sol-gel est mise au repos, conformément à l'invention, pendant un temps adéquat jusqu'à obtention d'une solution présentant une viscosité sensiblement constante. Généralement, l'étape b) est réalisée à température ambiante pendant une durée s'échelonnant d'une semaine à 4 mois. Pendant cette phase dite de mûrissement, les précurseurs métalliques solubilisés (c'est-à-dire les précurseurs à base de plomb, de titane et de zirconium et de métal lanthanide) condensent jusqu'à un état d'équilibre. Cette condensation se traduit par une augmentation de la viscosité de la solution sol-gel, jusqu'à atteindre une valeur sensiblement constante en fonction du temps, lorsque l'état d'équilibre est atteint. En pratique, la solution préparée en a) est placée au repos, généralement, à température ambiante et en l'absence de tout chauffage. Parallèlement, la viscosité de la solution est mesurée à intervalles réguliers. Une fois que celle-ci présente une viscosité sensiblement constante, atteinte au bout d'une période allant de 1 semaine à 4 mois, la solution est diluée selon un taux prédéterminé de dilution (étape c). Ce taux de dilution sera choisi par l'homme du métier selon l'utilisation envisagée de la solution sol-gel, et notamment selon l'épaisseur de matériau souhaité après dépôt et traitement d'une telle solution sur un substrat.

Cette dilution peut consister à diluer la solution sol-gel obtenue à l'issue de l'étape b) par un facteur de dilution s'échelonnant de 1 à 20.

Selon l'invention, le solvant de dilution doit être miscible avec le solvant diol de préparation de la solution de l'étape a). Il peut être identique au solvant diol de préparation de la solution sol-gel de l'étape a) ou peut être différent et choisi par exemple, parmi les monoalcools aliphatiques tels que définis ci-dessus.

De préférence, le solvant de dilution est un solvant diol identique à celui utilisé dans l'étape a).

Les solutions sol-gel ainsi préparées peuvent être utilisées directement pour constituer des dépôts ou encore, compte tenu de leur stabilité à long terme, être utilisées ultérieurement. Ces solutions sol-gel peuvent donc faire office de solutions commerciales, destinées à être utilisées ultérieurement en vue d'être transformée en matériau céramique oxyde.

L'invention a ainsi pour objet également une solution sol-gel susceptible d'être obtenue par un procédé tel que défini précédemment.

L'invention concerne également un procédé de préparation d'un matériau en céramique oxyde comprenant du plomb, du titane, du zirconium, et un métal lanthanide, ledit procédé comprenant au moins un cycle d'étapes comprenant successivement :
d) une étape de dépôt d'une couche d'une solution sol-gel sur un substrat, ladite solution sol-gel étant obtenue par le procédé précédemment décrit ;
e) une étape de traitement thermique de ladite couche en vue de la transformer en matériau céramique oxyde.

Ce procédé de fabrication présente l'avantage d'être un procédé reproductible, c'est-à-dire donnant toujours les mêmes performances diélectriques de films pour les mêmes conditions de fabrication de la solution, et d'être un procédé répétable, c'est à dire reproductible dans le temps grâce à l'utilisation d'une solution sol-gel stable. La solution sol-gel stable issue du procédé décrit précédemment, dont les caractéristiques physico-chimiques (viscosité, état de condensation des espèces moléculaires en solution, etc) restent uniformes en fonction du temps, garantit une reproductibilité et une répétabilité des épaisseurs de matériaux déposés sur le substrat et également des ses propriétés diélectriques. Par conséquent, ce procédé, qui ne nécessite pas de réajustement des paramètres de fabrication pour garantir un résultat reproductible ou répétable, est tout à fait adapté à un niveau industriel.

Ainsi, la première étape consiste à déposer sur un substrat la solution sol-gel stable, préparée selon le procédé précédemment décrit, sous forme d'une couche.

Ce dépôt peut être effectué par toute technique permettant d'obtenir un dépôt sous forme de couches minces. Les épaisseurs de couches minces déposées, selon l'invention, peuvent aller de 1 à 500 nm.

Le dépôt peut se faire selon l'une des techniques suivantes :
- le trempage-retrait (connu sous la terminologie anglaise « dip-coating ») ;
- l'enduction centrifuge (connue sous la terminologie anglaise « spin-coating ») ;
- l'enduction laminaire (connue sous la terminologie anglaise « laminar-flow-coating ou meniscus coating ») ;
- la pulvérisation (connue sous la terminologie anglaise « spray-coating ») ;
- l'épandage (connu sous la terminologie anglaise « soak coating ») ;
- l'enduction au rouleau (connue sous la terminologie « roll- to- roll process ») ;
- l'enduction au pinceau (connue sous la terminologie anglaise « paint coating ») ;
- la sérigraphie (connue sous la terminologie anglaise « screen printing »).

Toutefois, de préférence, le dépôt sera réalisé par la technique du trempage-retrait (appelée communément « dip-coating » en anglais) ou encore par la technique de l'enduction centrifuge (appelée communément « spin-coating » en anglais). Ces techniques facilitent, notamment, un contrôle précis des épaisseurs de couches déposées.

En ce qui concerne la technique de l'enduction centrifuge, le substrat destiné au dépôt est plaqué sur un support tournant. Ensuite, l'on dépose un volume de solution sol-gel permettant de recouvrir ledit substrat. La force centrifuge étale ladite solution sous forme d'une couche mince. L'épaisseur de la couche est notamment fonction de la vitesse de centrifugation et de la concentration de la solution. Le paramètre de la concentration de la solution étant fixé, l'homme du métier peut aisément choisir une vitesse de centrifugation voulue pour une épaisseur de couche désirée.

Selon l'invention, le substrat destiné au dépôt peut être de divers types, mais ne doit pas, de préférence, contaminer la couche déposée, par migrations d'ions par exemple, lors du traitement thermique et doit de préférence permettre une bonne adhérence de la couche. Sa température de ramollissement doit être avantageusement supérieure à la température de traitements thermiques des couches déposées et son coefficient de dilatation thermique doit être avantageusement du même ordre de grandeur que celui desdites couches pour limiter les effets de contrainte lors du recuit.

Selon l'invention, le substrat est de préférence une tranche de silicium éventuellement revêtue d'une couche métallique. Ce type de substrat présente avantageusement une bonne planéité et un excellent état de surface et permet, notamment, des recuits à haute température, sans subir d'altérations.

Ce substrat peut comporter une couche barrière sur la ou lesdites faces qui servent de face de dépôt, cette couche barrière ayant pour fonction d'empêcher une migration des atomes du substrat vers la (les) couches déposées obtenues après traitement thermique. Cette couche barrière a également pour fonction de diminuer les pertes diélectriques des matériaux obtenus avec le procédé de l'invention. La couche barrière est déposée préalablement à la mise en oeuvre de l'étape d).

Cette couche barrière peut être en un matériau choisi parmi les oxydes métalliques à structure pérovskite et en particulier peut être en PbTiO₃ ou en SrTiO₃.

Cette couche barrière peut présenter une épaisseur allant de 1 à 100 nm, de préférence inférieure à 50 nm. Pour obtenir de telles couches, l'on peut partir de solutions sol-gel présentant une concentration entre 2,5 et 20%, et de préférence entre 2,5 et 10% en équivalent massique de l'oxyde métallique obtenu.

De préférence, la couche barrière est en PbTiO₃.

Dans ce dernier cas, elle peut être préparée par un procédé comprenant successivement les étapes suivantes :
- dépôt sur la ou lesdites faces du substrat d'au moins une couche d'une solution sol-gel précurseur de PbTiO₃ ;
- traiter thermiquement ladite couche en vue de transformer ladite solution sol-gel en PbTiO₃.

Cette solution sol-gel précurseur de PbTiO₃ peut être avantageusement préparée par le procédé comprenant les étapes suivantes :
- préparer une solution sol-gel, par mise en contact d'un précurseur moléculaire de plomb, d'un précurseur moléculaire de titane avec un milieu comprenant un solvant diol et éventuellement un monoalcool aliphatique ;
- mettre au repos la solution obtenue selon l'étape ci-dessus pendant un temps suffisant nécessaire à l'obtention d'une solution présentant une viscosité sensiblement constante ;
- diluer à un taux prédéterminé la solution obtenue par l'étape ci-dessus avec un solvant diol identique à celui de la première étape (ou étape de préparation de la solution sol-gel) ou un solvant miscible avec le solvant diol utilisé dans la première étape.

En particulier, la préparation de la solution sol-gel de la première étape peut être mise en oeuvre par un procédé comprenant :
- la préparation d'une première solution par dissolution d'un précurseur moléculaire de plomb, dans un milieu organique comprenant un solvant diol;
- la préparation d'une deuxième solution par dissolution d'un précurseur moléculaire de titane dans un milieu organique comprenant un monoalcool aliphatique et éventuellement un solvant diol identique à celui utilisé dans la première étape ;
- le mélange de ladite première solution et de ladite seconde solution, éventuellement en chauffant à reflux.

Les conditions opératoires pour la mise en oeuvre des procédés décrits ci-dessus (nature des précurseurs, nature des solvants, temps de mûrissement...) sont identiques à celles déjà décrites pour le procédé de préparation d'une solution sol-gel précurseur de la céramique oxyde à base de métal lanthanide, de plomb, de titane et de zirconium.

De même, le traitement thermique nécessaire pour la céramisation de la couche barrière est identique à celui décrit ci-dessous pour la céramisation d'une couche d'une solution sol-gel à base de titane, zirconium, plomb et lanthane.

Une fois que le dépôt de la solution sol-gel précurseur d'une céramique oxyde à base de métal lanthanide, de titane, de zirconium et de plomb est effectué sur une face du substrat éventuellement recouverte d'une couche barrière, le procédé de l'invention comprend un traitement thermique de la ou les couches déposées, de manière à les transformer en la céramique souhaitée.

Selon le procédé de l'invention, lorsque le cycle d'étapes mentionné plus haut est mis en oeuvre n fois, n correspond au nombre de répétitions du cycle, n étant un entier allant de 2 à 50, le traitement thermique comprend avantageusement :
* pour chacune des (n-1) premières couches déposées, un cycle d'étapes comprenant successivement :
   - une étape de séchage de chaque couche déposée ;
   - une étape de calcination de ladite couche
   - éventuellement une étape de pré-recuit de ladite couche ;
* pour la nième couche déposée, un cycle d'étapes comprenant successivement:
   * une étape de séchage de ladite couche ;
   * une étape de calcination de ladite couche ;
   * une étape de pré-recuit de ladite couche ;
ledit traitement thermique étant finalisé par une étape de recuit de l'ensemble desdites couches déposées (c'est-à-dire des n couches).

En d'autres termes, pour les (n-1) premières couches, chacune desdites couches subira successivement une étape de séchage, une étape de calcination suivie éventuellement d'une étape de pré-recuit. Puis, la n^{ième} couche déposée sur l'empilement des (n-1) premières couches, subira successivement une étape de séchage suivi d'une étape de calcination et d'une étape de pré-recuit. Enfin, le traitement thermique sera finalisé par une étape de recuit de l'empilement complet.

Quelle que soit l'alternative envisagée, chaque couche de solution déposée subit, selon l'invention, une étape consistant en une étape de séchage de la couche déposée de manière à assurer une gélification de la couche. Cette étape est destinée à assurer l'évaporation d'une partie du solvant du type diol et d'une partie du solvant de dilution et éventuellement des produits secondaires, tels que des esters, issus des réactions entre les précurseurs métalliques. A l'issue de cette étape, la solution sol-gel déposée est transformée totalement en une couche de gel d'épaisseur constante adhérant à la surface du substrat. La température et la durée efficaces pour assurer la gélification peuvent être déterminées aisément, par l'homme du métier, à l'aide, par exemple, de techniques de spectrométrie IR.

Par exemple, l'étape de séchage, selon l'invention, peut être effectuée à une température inférieure à 100°C, par exemple à température ambiante pour une durée allant de 1 à 10 minutes. En d'autres termes, cette étape de dépôt consistera à mettre au repos la couche, juste après le dépôt, pour qu'elle sèche.

Après séchage, chaque couche subit une étape de calcination effectuée à une température et une durée pour éliminer totalement des composés organiques de la couche déposée et en particulier les solvants de préparation et de dilution de la solution sol-gel et les composés générés par la réaction des précurseurs moléculaires entre eux. La température et durée efficaces peuvent être déterminées aisément par l'homme du métier grâce à des techniques telles que la spectroscopie IR (Infra-rouge).

La durée de calcination pour une température donnée, correspond à une durée permettant l'obtention d'une épaisseur de couche constante. L'épaisseur de couche est contrôlée, par exemple, par des techniques de profilométrie. L'étape de calcination est arrêtée à l'obtention d'une couche homogène en épaisseur et exempt de composés organiques.

De préférence, cette étape de calcination s'effectue à une température allant d'environ 300 à environ 380°C et pour une durée allant d'environ 30 secondes à environ 20 minutes.

Avantageusement, lorsque le procédé comprend le dépôt de plusieurs couches, les (n-1) premières couches déposées peuvent être amenées à subir une étape de pré-recuit, consistant en un chauffage à une température supérieure à 380°C et allant jusqu'à 450°C, de préférence entre 385 et 405°C pendant une durée pouvant aller de 1 minute à 60 minutes, de préférence pendant une durée supérieure à 15 minutes, par exemple supérieure à 20 minutes.

De préférence, cette étape de pré-recuit est mise uniquement en oeuvre sur la dernière couche (dite n^{ième} couche) (ou en d'autres termes sur l'empilement des n couches déposées) dans des conditions opératoires (température, durée) identiques à celles décrites dans le paragraphe ci-dessus.

Cette étape de pré-recuit permet d'améliorer les performances diélectriques des couches, dans la mesure où cette étape permet d'éviter la formation d'une phase pyrochlore défavorable pour les propriétés diélectriques. De plus, cette étape de pré-recuit dans les conditions opératoires précitées permet de relaxer une partie des contraintes accumulées dans les couches lors des traitements précédant cette étape et d'éliminer les impuretés carbonées subsistant encore après l'étape de calcination. Cette étape permet également de stabiliser lesdites couches.

Enfin, après l' étape de pré-recuit, le traitement thermique comprend une étape de recuit réalisée à une durée et une température efficaces pour permettre la cristallisation de la couche déposée ou de l'ensemble des couches déposées. La cristallisation de la couche correspond à l'obtention d'une couche d'épaisseur stabilisée et de structure cristallisée, du type pérovskite. La température et la durée de recuit sont choisies de manière à obtenir cette cristallisation, vérifiable aisément par analyse structurale, telle que l'analyse par diffraction des rayons X. De préférence, le recuit est effectué à une température allant d'environ 500 à environ 800°C pour une durée comprise entre environ 30 secondes et environ 1 heure. Lorsque le procédé comprend le dépôt de plusieurs couches, l'étape de recuit est réalisé avantageusement sur l'empilement complet de couches, chacune des (n-1) premières couches de l'empilement ayant subi préalablement une étape de séchage, une étape calcination et une étape de pré-recuit.

Le recuit peut être effectué par différentes techniques. De préférence, le recuit est réalisé par un mode de chauffage rapide, obtenu, par exemple, avec la technique du « recuit thermique rapide » (communément désigné par l'abréviation RTA pour « Rapid Thermal Annealing » ou RTP pour « Rapid Thermal Process »).

Les étapes de dépôt de la solution sol-gel et de traitement thermique peuvent être réitérées une ou plusieurs fois, jusqu'à l'obtention d'un matériau présentant l'épaisseur désirée.

Selon l'invention, le film constitué par le dépôt d'au moins une couche, permet, à l'issue du traitement thermique du procédé, d'obtenir un film en céramique oxyde comprenant un métal lanthanide, du plomb, du titane et du zirconium, cristallisé dans un système unique correspondant au système pérovskite, avec une légère orientation préférentielle correspondant à la direction [111] du substrat. Aucune phase pyrochlore n'a été détectée avec le procédé de l'invention.

L'invention a enfin trait à un matériau en céramique oxyde comprenant du plomb, du titane, du zirconium et un métal lanthanide susceptible d'être obtenu par un procédé tel que défini ci-dessus.

L'invention va maintenant être décrite en référence aux exemples suivants donnés à titre illustratif et non limitatif.

### EXPOSÉ DÉTAILLÉ DE MODES DE RÉALISATION PARTICULIERS

### EXEMPLE 1 : Préparation d'une solution sol-gel stable de composition 9/52/48, soit Pb_{1,01}La_{0,09}Zr_{0,52}Ti_{0,48}O_{3,145}.

Cet exemple de préparation comprend plusieurs étapes :
- une étape de préparation d'une première solution sol-gel à base de plomb et de lanthane (paragraphe a) ci-dessous) ;
- une étape de préparation d'une deuxième solution sol-gel à base de titane et de zirconium (paragraphe b) ci-dessous) ;
- une étape de mélange de ladite première solution et de ladite seconde solution (paragraphe c) ci-dessous).

### a) Préparation de la première solution sol-gel à base de plomb et de lanthane.

Dans cet exemple, les précurseurs moléculaires de plomb et de lanthane sont l'acétate de plomb et l'acétate de lanthane.

Dans un tricol surmonté d'un montage de distillation, on pèse 208,6 g (0,55 mol) d'acétate de plomb trihydrate, 15,8 g (0,045 mol) d'acétate de lanthane contenant 10% en masse d'eau et 260 g (5,32 mol) d'éthylène glycol. On homogénéise le mélange pendant 30 minutes à 70°C de manière à permettre une dissolution complète de l'acétate de plomb puis pendant 15 minutes à 105°C pour dissoudre l'acétate de lanthane. La température de la solution homogène obtenue est alors augmentée pour déshydrater les précurseurs au plomb et au lanthane par distillation (température des vapeur de l'ordre de 100°C). Au cours de la distillation, on observe le jaunissement de la solution. On recueille 30 g de distillat et la concentration en Pb de la solution d'alcoxyde de plomb est de l'ordre de 1,21 mol/kg.

### b) Préparation de la deuxième solution à base de titane et de zirconium.

Sous balayage d'argon, dans 80 g (100 mL) de 1-propanol, on additionne sous agitation 68,22 g (0,24 mol) d'isopropoxyde de titane et on ajoute 121,67 g (0,26 mol) de propoxyde de zirconium à 70% dans du 1-propanol et dans l'éthylène glycol (140 g). On laisse sous agitation 10 minutes à température ambiante.

### c) Mélange de la première solution et de la deuxième solution.

Dans le tricol contenant la solution précurseur à base de plomb et de lanthane préalablement préparée et chauffée à 60°C, on additionne rapidement, sous courant d'argon, la solution préparée en b) sous forte agitation (600 t/min). L'alcoxyde de plomb est en excès de 10% pour pallier la perte d'oxyde de plomb (PbO) lors du traitement thermique des films. A la fin de l'addition, on place un réfrigérant surmonté d'une garde dessicante et on arrête le balayage d'argon. On chauffe au reflux pendant 2 heures (104°C). Au cours de la montée en température, on diminue l'agitation à 250 t/min. On obtient après reflux une solution qui a une concentration de l'ordre de 26% en équivalent massique PLZT. Ensuite, la solution est conservée à température ambiante sans agitation pendant une semaine de mûrissement. La solution est ensuite diluée à 20% en équivalent massique PLZT (soit 0,67 M) par addition de la quantité appropriée d'éthylène glycol.

### EXEMPLE 2 : Préparation d'une solution sol-gel stable de composition 9/65/35 soit Pb_{1,01}La_{0,09}Zr_{0,65}Ti_{0,35}O_{3,145}.

Cet exemple de préparation comprend plusieurs étapes :
- une étape de préparation d'une première solution sol-gel à base de plomb et de lanthane (paragraphe a) ci-dessous) ;
- une étape de préparation d'une deuxième solution sol-gel à base de titane et de zirconium (paragraphe b) ci-dessous) ;
- une étape de mélange de ladite première solution et de ladite seconde solution (paragraphe c) ci-dessous).

### a) Préparation de la première solution sol-gel à base de plomb et de lanthane.

Les précurseurs moléculaires de plomb et de lanthane sont respectivement l'acétate de plomb et de l'acétate de lanthane.

Dans un tricol surmonté d'un montage de distillation,on pèse 208.6 g (0,55 mol) d'acétate de plomb trihydrate, 15,8 g (0,045 mol) d'acétate de lanthane contenant 10% en masse d'eau et 260 g (5,32 mol) d'éthylène glycol. On homogénéise le mélange pendant 30 minutes à 70°C de manière à permettre une dissolution complète de l'acétate de plomb puis pendant 15 minutes à 105°C pour dissoudre l'acétate de lanthane. La température de la solution homogène obtenue est alors augmentée pour déshydrater les précurseurs moléculaires de plomb et de lanthane par distillation (température des vapeurs de l'ordre de 100°C). Au cours de la distillation, on observe le jaunissement de la solution. On recueille 30 g de distillat et la concentration en plomb de la solution d'alcoxyde de plomb est de l'ordre de 1,21 mol/kg.

### b) Préparation de la deuxième solution à base de titane et de zirconium.

Sous balayage d'argon, dans 80 g (100 mL) de 1-propanol, on additionne sous agitation 49,75 g (0,175 mol) d'isopropoxyde de titane et on ajoute 152,1 g (0,325 mol) de n-propoxyde de zirconium à 70% dans du 1-propanol. On laisse sous agitation à température ambiante.

### c) Mélange de la première solution et de la deuxième solution.

Dans un tricol contenant la première solution précurseur à base de plomb et de lanthane préalablement préparée et chauffée à 60°C, on additionne rapidement, sous courant d'argon, la deuxième solution préparée en b) sous forte agitation (600 tours/min). L'alcoxyde de plomb est en excès de 10% pour pallier la perte d'oxyde de plomb (PbO) lors du traitement thermique des films. A la fin de l'addition, on place un réfrigérant surmonté d'une garde dessicante et on arrête le balayage d'argon. On chauffe au reflux pendant 2 heures (104°C). Au cours de la montée en température, on diminue l'agitation à 250 tours/min. On obtient après reflux une solution qui a une concentration de l'ordre de 26% en équivalent massique PLZT. La solution est ensuite conservée à température ambiante sans agitation pendant 1 semaine. La solution est ensuite diluée à 20% en équivalent massique PLZT (soit 0,67 M) par addition de la quantité appropriée d'éthylène glycol.

### EXEMPLE 3-Préparation d'une solution sol-gel précurseur de PbTiO₃.

Cet exemple illustre la préparation d'une solution sol-gel précurseur de PbTiO₃, qui sert, dans le cadre de l'invention pour la préparation de couches barrières entre le substrat de dépôt et la céramique oxyde à base de lanthane, de plomb, de titane, de zirconium.

Dans un tricol surmonté d'un montage de distillation, on pèse 139,1 g (0,37 mol) d'acétate de plomb trihydrate, 60 g (0,97 mol) d'éthylène glycol. On homogénéise le mélange pendant 30 minutes à 70°C de manière à permettre une dissolution complète de l'acétate de plomb. La température de la solution homogène obtenue est alors augmentée pour déshydrater l'acétate de plomb (température de l'ordre de 100°C). Au cours de la distillation, on observe le jaunissement de la solution. On recueille 21 g de distillat et la concentration en plomb de la solution d'alcoxyde de plomb est de l'ordre de plomb de 2,08 mol/kg.

Sous balayage d'argon, dans 160 g de 1-propanol, on additionne sous agitation, 94,75 g (0,33 mol d'isopropoxyde de titane et 100 g (1,61 mol) d'éthylène glycol. On laisse sous agitation 15 minutes à température ambiante.

Dans le tricol contenant la solution précurseur à base de plomb préalablement préparée et chauffée à 60°C, on additionne rapidement, sous courant d'argon, la solution de titane sous forte agitation (300 tours/min). L'alcoxyde de plomb est en excès de 10% pour pallier la perte d'oxyde de plomb lors du traitement thermique de la solution déposée sous forme de couche. A la fin de l'addition, on place un réfrigérant surmonté d'une garde dessicante et on arrête le balayage d'argon. On chauffe à reflux pendant 15 minutes (100°C). On obtient après reflux une solution qui a une concentration de l'ordre de 21% en équivalent massique d'oxyde plomb et de titane. La solution est ensuite conservée à température ambiante sans agitation pendant 24 heures, durée à l'issue de laquelle elle présente une viscosité qui n'évolue plus. A l'issue de cette durée, la solution est diluée à une concentration allant de 5 à 10%.

### EXEMPTE 4 : PREPARATION DE FILMS EN CRAMIQUE OXYDE A BASE DE LANTHANE, DE PLOMB, DE TITANE ET DE ZIRCONIUM.

Cet exemple illustre la préparation d'un film en céramique par dépôt sur un substrat de trois couches de solutions sol-gel préparées préalablement selon les exemples décrits précédemment (Exemple 1 et 2). Le substrat choisi est une tranche de silicium orienté [111] d'un diamètre de 12,5 à 15 cm, ladite tranche étant métallisée par pulvérisation avec une couche de platine d'une épaisseur allant de 100 nm à 200 nm servant d'électrode inférieure. La technique de dépôt utilisée, dans cet exemple, est l'enduction centrifuge, qui permet d'ajuster, pour une solution de concentration donnée, l'épaisseur déposée en choisissant la vitesse de rotation adéquate du dispositif. Les dépôts sont réalisés en zone à empoussièrement contrôlé afin de limiter la présence d'inclusions particulaires dans les films et en ambiance climatisée (température et hygrométrie contrôlées) afin de garantir la reproductibilité des conditions d'évaporation.

La solution sol-gel diluée à 20 % en masse est filtrée sur filtre 0,2 µm préalablement au dépôt sur tranche. La vitesse de rotation, pour effecteur le dépôt, est ajustée à 4500 tours/min, afin d'obtenir une épaisseur finale par couche unitaire déposée allant de 50 à 70 nm.

La couche déposée est ensuite gélifiée par 2 minutes de séchage à 50°C. Après le séchage et le chauffage du dépôt, la couche subit une calcination à une température de 360 °C pendant 2 minutes.

Dans cet exemple, l'opération de dépôt de couche suivi du traitement précédemment exposé (séchage, calcination) est réalisée trois fois.

Enfin, l'empilement de trois couches obtenu est soumis à un traitement de pré-recuit par chauffage à 390°C pendant 20 minutes sous atmosphère d'air suivi d'une étape de recuit à une température de 700 °C pendant 5 minutes.

Cet exemple a été reproduit deux fois avec la solution préparée à l'exemple 1. Les films obtenus intitulés respectivement film 1 et film 2 présentent les caractéristiques suivantes :

| Film | Epaisseur du film | Capacité (nF/mm²) à 0V/10 kHz | Constante diélectrique à 0V/10 kHz |
|---|---|---|---|
| 1 | 170 nm | 48 | 921 |
| 2 | 207 nm | 40,5 | 947 |

Cet exemple a également été reproduit 2 fois avec la solution dont la préparation est explicitée à l'exemple 2. Les films obtenus intitulés respectivement film 3 et film 4 présentent les caractéristiques suivantes :

| Film | Epaisseur du film | Capacité (nF/mm²) à 0V/10 kHz | Constante diélectrique à 0V/10 kHz |
|---|---|---|---|
| 3 | 175 nm | 41 | 810 |
| 4 | 160 nm | 45 | 810 |

### EXEMPLE 5.

Cet exemple illustre la préparation d'un film en céramique de formule Pb_{1,01} La_{0,09} Zr_{0,65} Ti_{0,35}O_{3,145} par dépôt sur un substrat de trois couches de solutions sol-gel préparées préalablement selon l'exemple 2, ce dépôt s'effectuant non plus en contact direct avec le substrat mais en contact avec une couche barrière en PbTiO₃, préalablement déposée.

Cette couche barrière est réalisée par dépôt d'une couche de solution sol-gel telle que préparée dans l'exemple 3 par enduction centrifuge (4500 tours/min) suivi d'un traitement thermique, comprenant un séchage de la couche à 50°C et d'une calcination à 360°C.

Une fois la couche barrière déposée, le dépôt du film est effectué conformément à ce qui est exposé dans l'exemple 4 ci-dessus.

Le film obtenu intitulé film 5 présente les caractéristiques suivantes :

| Film | Epaisseur du film | Capacité (nF/mm²) à 0V/10 kHz | Perte diélectrique | Constante diélectrique à 0V/10 kHz |
|---|---|---|---|---|
| 5 | 180 nm | 39 | 6% | 793 |

Comparativement au film 3, qui présente une perte diélectrique de l'ordre de 9%, le film 5 présente une perte diélectrique moindre et une capacité sensiblement identique.

Ceci démontre que la présence d'une couche barrière permet de diminuer les pertes diélectriques du film déposé sans en détériorer la capacité.

## Revendications

1. Procédé de préparation d'un matériau en céramique oxyde comprenant du plomb, du titane, du zirconium et un métal lanthanide, ledit procédé comprenant un cycle d'étapes mis en oeuvre n fois, n correspondant au nombre de répétitions du cycle et étant un entier allant de 2 à 50, chaque cycle comprenant successivement :
d) une étape de dépôt d'une couche d'une solution sol-gel sur au moins une des faces d'un substrat, ladite solution sol-gel étant obtenue par le procédé comprenant successivement les étapes suivantes :
a) préparer une solution sol-gel, par mise en contact d'un précurseur moléculaire de plomb, d'un précurseur moléculaire de titane, d'un précurseur moléculaire de zirconium et d'un précurseur moléculaire du métal lanthanide avec un milieu comprenant un solvant diol et éventuellement un monoalcool aliphatique ;
b) mettre au repos la solution obtenue en a) pendant un temps suffisant nécessaire à l'obtention d'une solution présentant une viscosité sensiblement constante, ce temps s'échelonnant de 1 semaine à 4 mois ;
c) diluer à un taux prédéterminé la solution obtenue en b) avec un solvant diol identique à celui de l'étape a) ou un solvant miscible avec le solvant diol utilisé dans l'étape a),
e) une étape de traitement thermique de ladite couche en vue de la transformer en la céramique oxyde,
ledit traitement thermique comprenant :
* pour chacune des (n-1) premières couches déposées, un cycle d'étapes comprenant successivement :
- une étape de séchage de chaque couche déposée ;
- une étape de calcination de ladite couche
- éventuellement une étape de pré-recuit de ladite couche ;
* pour la nième couche déposée, un cycle d'étapes comprenant successivement:
* une étape de séchage de ladite couche ;
* une étape de calcination de ladite couche ; et
* une étape de pré-recuit de ladite couche ;
ledit traitement thermique étant finalisé par une étape de recuit de l'ensemble desdites couches déposées (c'est-à-dire des n couches).

2. Procédé selon la revendication 1, dans lequel le précurseur moléculaire de plomb est choisi parmi les sels inorganiques de plomb, les composés orgométalliques de plomb.

3. Procédé selon la revendication 2, dans lequel le sel inorganique de plomb est choisi parmi le chlorure de plomb, le nitrate de plomb.

4. Procédé selon la revendication 2, dans lequel le composé organométallique de plomb est choisi parmi l'acétate de plomb, les alcoxydes de plomb.

5. Procédé selon l'une quelconque des revendications précédentes, dans lequel le précurseur moléculaire du métal lanthanide est un précurseur moléculaire de lanthane.

6. Procédé selon la revendication 5, dans lequel le précurseur moléculaire de lanthane est un composé organométallique de lanthane.

7. Procédé selon la revendication 6, dans lequel le composé organométallique de lanthane est l'acétate de lanthane.

8. Procédé selon la revendication 5, dans lequel le précurseur moléculaire de lanthane est un sel inorganique de lanthane.

9. Procédé selon la revendication 8, dans lequel le sel inorganique de lanthane est choisi parmi le nitrate de lanthane, le chlorure de lanthane.

10. Procédé selon l'une quelconque des revendications précédentes, dans lequel le précurseur moléculaire de titane est un composé organométallique de titane.

11. Procédé selon la revendication 10, dans lequel le composé organométallique de titane est un alcoxyde de titane.

12. Procédé selon l'une quelconque des revendications précédentes, dans lequel le précurseur moléculaire de zirconium est un composé organométallique de zirconium.

13. Procédé selon la revendication 12, dans lequel le composé organométallique de zirconium est un alcoxyde de zirconium.

14. Procédé selon l'une quelconque des revendications 1 à 13, dans lequel le solvant diol utilisé dans l'étape a) et éventuellement l'étape c) est un alkylène glycol ayant un nombre d'atomes de carbone allant de 2 à 5.

15. Procédé selon la revendication 14, dans lequel le solvant diol est l'éthylène glycol.

16. Procédé selon l'une quelconque des revendications 1 à 15, dans lequel le monoalcool aliphatique comprend de 1 à 6 atomes de carbone.

17. Procédé selon l'une quelconque des revendications 1 à 16, dans lequel, lorsque le métal lanthanide est du lanthane, l'étape a) comprend :
- la préparation d'une première solution par dissolution, dans un milieu organique comprenant un solvant diol, d'un précurseur moléculaire de plomb et d'un précurseur moléculaire de lanthane ;
- la préparation d'une deuxième solution par dissolution d'un précurseur moléculaire de titane et d'un précurseur moléculaire de zirconium dans un milieu organique comprenant un monoalcool aliphatique, et éventuellement un solvant diol identique à celui utilisé dans la précédente étape ;
- le mélange de ladite première solution et de ladite seconde solution, éventuellement en chauffant à reflux.

18. Procédé selon l'une quelconque des revendications précédentes, dans lequel le solvant utilisé dans l'étape c) est un monoalcool aliphatique.

19. Procédé de préparation selon la revendication 1, dans lequel l'étape de dépôt d) s'effectue par trempage-retrait.

20. Procédé de préparation selon la revendication 1, dans lequel l'étape de dépôt d) s'effectue par enduction centrifuge.

21. Procédé de préparation selon l'une quelconque des revendications 1 à 20, dans lequel le substrat est une tranche de silicium.

22. Procédé de préparation selon l'une quelconque des revendications 1 à 21, dans lequel ladite ou lesdites faces du substrat sont recouvertes, préalablement à l'étape d), d'une couche barrière comprenant un matériau choisi parmi les oxydes métalliques à structure pérovskite.

23. Procédé de préparation selon la revendication 22, dans lequel la couche barrière est en un matériau choisi parmi PbTiO₃, SrTiO₃.

24. Procédé de préparation selon la revendication 23, dans lequel la couche barrière est en PbTiO₃.

25. Procédé de préparation selon la revendication 24, dans lequel la couche barrière est préparée par un procédé comprenant successivement les étapes suivantes :
- dépôt sur ladite ou lesdites faces du substrat d'au moins une couche d'une solution sol-gel précurseur de PbTiO₃ ;
- traitement thermique de ladite couche en vue de transformer ladite solution sol-gel en PbTiO₃.

26. Procédé de préparation selon la revendication 25, dans lequel la solution sol-gel précurseur de PbTiO₃ est préparée par un procédé comprenant les étapes suivantes :
- préparer une solution sol-gel, par mise en contact d'un précurseur moléculaire de plomb, d'un précurseur moléculaire de titane avec un milieu comprenant un solvant diol et éventuellement un monoalcool aliphatique ;
- mettre au repos la solution obtenue selon l'étape ci-dessus pendant un temps suffisant nécessaire à l'obtention d'une solution présentant une viscosité sensiblement constante ;
- diluer à un taux prédéterminé la solution obtenue par l'étape ci-dessus avec un solvant diol identique à celui de la première étape ou un solvant miscible avec le solvant diol utilisé dans la première étape.

27. Procédé de préparation selon la revendication 1, dans lequel l'étape de séchage consiste à mettre au repos la couche, après dépôt, à une température inférieure à 100°C pendant une durée allant de 1 minute à 10 minutes.

28. Procédé de préparation selon la revendication 1, dans lequel l'étape de calcination est réalisée à une température allant de 300 à 380°C pendant une durée allant de 30 secondes à 20 minutes.

29. Procédé de préparation selon la revendication 1, dans lequel l'étape de recuit est réalisée à une température allant de 500 à 800°C pendant une durée allant de 30 secondes à 1 heure.

30. Procédé de préparation selon la revendication 29, dans lequel l'étape de pré-recuit est réalisée à une température supérieure à 380°C et allant jusqu'à 450°C, de préférence entre 385 et 405°C pendant une durée allant de 1 minute à 60 minutes.

## Claims

1. A method of preparing an oxide ceramic material comprising lead, titanium, zirconium and a lanthanide metal, said method comprising a cycle of steps carried out n times, n corresponding to the number of repetitions of the cycle and being an integer ranging from 2 to 50, each cycle comprising :
d) a step of depositing a layer of a sol-gel solution on at least one of the faces of a substrate, said sol-gel solution being obtained by a method comprising in succession the following steps :
a) preparing a sol-gel solution by bringing a lead-containing molecular precursor, a titanium-containing molecular precursor, a zirconium-containing molecular precursor and a lanthanide-metal-containing molecular precursor into contact with a medium comprising a diol solvent and optionally an aliphatic monoalcohol;
b) leaving the solution obtained in step a) to stand for a sufficient time needed to obtain a solution having an approximately constant viscosity, this time ranging from one week to four months; and
c) diluting the solution obtained in step b) is diluted to a predetermined amount with a diol solvent identical to that of step a) or a solvent miscible with the diol solvent used in step a),
e) a step of heat treating said layer for the purpose of converting it into the oxide ceramic,
the heat treatment comprising:
* for each of the (n-1) first layers deposited, a cycle of steps comprising, in succession:
- a step of drying each deposited layer,
- a step of calcining said layer and
- optionally, a step of preannealing said layer;
* for the nth layer deposited, a cycle of steps comprising, in succession:
- a step of drying said layer,
- a step of calcining said layer and
- a step of preannealing said layer,
said heat treatment being completed with a step of annealing all said deposited layers (i.e. all n layers).

2. The method as claimed in claim 1, in which the lead-containing molecular precursor is chosen from inorganic lead salts and organometallic lead compounds.

3. The method as claimed in claim 2, in which the inorganic lead salt is chosen from lead chloride and lead nitrate.

4. The method as claimed in claim 2, in which the organometallic lead compound is chosen from lead acetate and lead alkoxides.

5. The method as claimed in any one of the preceding claims, in which the lanthanide-metal-containing molecular precursor is a lanthanum-containing molecular precursor.

6. The method as claimed in claim 5, in which the lanthanum-containing molecular precursor is an organometallic lanthanum compound.

7. The method as claimed in claim 6, in which the organometallic lanthanum compound is lanthanum acetate.

8. The method as claimed in claim 5, in which the lanthanum-containing molecular precursor is an inorganic lanthanum salt.

9. The method as claimed in claim 8, in which the inorganic lanthanum salt is chosen from lanthanum nitrate and lanthanum chloride.

10. The method as claimed in any one of the preceding claims, in which the titanium-containing molecular precursor is an organometallic titanium compound.

11. The method as claimed in claim 10, in which the organometallic titanium compound is a titanium alkoxide.

12. The method as claimed in any one of the preceding claims, in which the zirconium-containing molecular precursor is an organometallic zirconium compound.

13. The method as claimed in claim 12, in which the organometallic zirconium compound is a zirconium alkoxide.

14. The method as claimed in any one of claims 1 to 13, in which the diol solvent used in step a) and optionally step c) is an alkylene glycol having a number of carbon atoms ranging from 2 to 5.

15. The method as claimed in claim 14, in which the diol solvent is ethylene glycol.

16. The method as claimed in any one of claims 1 to 15, in which the aliphatic monoalcohol contains 1 to 6 carbon atoms.

17. The method as claimed in any one of claims 1 to 16, in which, when the lanthanide metal is lanthanum, step a) comprises:
- the preparation of a first solution by dissolving a lead-containing molecular precursor and a lanthanum-containing molecular precursor in an organic medium comprising a diol solvent;
- the preparation of a second solution by dissolving a titanium-containing molecular precursor and a zirconium-containing molecular precursor in an organic medium comprising an aliphatic monoalcohol and, optionally, a diol solvent identical to that used in the preceding step; and
- the mixing of said first and second solutions, optionally heating to reflux.

18. The method as claimed in any one of the preceding claims, in which the solvent used in step c) is an aliphatic monoalcohol.

19. The method of preparation as claimed in claim 1, in which deposition step d) is carried out by dip coating.

20. The method of preparation as claimed in claim 1, in which deposition step d) is carried out by spin coating.

21. The method of preparation as claimed in any one of claims 1 to 20, in which the substrate is a silicon wafer.

22. The method of preparation as claimed in any one of claims 1 to 21, in which said face or faces of the substrate are covered, prior to step d), with a barrier layer comprising a material chosen from metal oxides of perovskite structure.

23. The method of preparation as claimed in claim 22, in which the barrier layer is made of a material chosen from PbTiO₃ and SrTiO₃.

24. The method of preparation as claimed in claim 23, in which the barrier layer is made of PbTiO₃.

25. The method of preparation as claimed in claim 24, in which the barrier layer is prepared by a method comprising, in succession, the following steps:
- deposition of at least one layer of a PbTiO₃ precursor sol-gel solution on said face(s) of the substrate; and
- heat treatment of said layer for the purpose of converting said sol-gel solution into PbTiO₃.

26. The method of preparation as claimed in claim 25, in which the PbTiO₃ precursor sol-gel solution is prepared by a method comprising the following steps :
- a sol-gel solution is prepared by bringing a lead-containing molecular precursor and a titanium-containing molecular precursor into contact with a medium comprising a diol solvent and optionally an aliphatic monoalcohol;
- the solution obtained in the above step is left to stand for a sufficient time needed to obtain a solution having an approximately constant viscosity; and
- the solution obtained by the above step is diluted to a predetermined level with a diol solvent identical to that of the first step or a solvent miscible with the diol solvent used in the first step.

27. The method of preparation according to claim 1, in which the drying step consists, after deposition, in letting the layer stand at a temperature below 100°C for a time ranging from, 1 minute to 10 minutes.

28. The method of preparation according to claim 1, in which the calcination step is carried out at a temperature ranging from 300 to 380°C for a time ranging from 30 seconds to 20 minutes.

29. The method of preparation according to claim 1, in which the annealing step is carried out at a temperature ranging from 500 to 800°C for a time ranging from 30 seconds to 1 hour.

30. The method of preparation as claimed in claim 29, in which the preannealing step is carried out at a temperature above 380°C and ranging up to 450°C, preferably between 385 and 405°C, for a time ranging from 1 minute to 60 minutes.

## Patentansprüche

1. Verfahren zur Herstellung eines Materials aus einer Blei, Titan, Zirkon und ein Lanthanidenmetall enthaltenden Oxydkeramik, wobei das Verfahren einen n-mal ausgeführten Zyklus von Verfahrensschritten umfasst, wobei n die Zahl der Wiederholungen des Zyklus bedeutet und eine ganze Zahl im Bereich von 2 bis 50 ist, und wobei jeder Zyklus jeweils aufeinanderfolgend umfaßt:
d) eine Verfahrensstufe der Abscheidung einer Schicht einer Sol-Gel- Lösung auf wenigstens einer der Oberflächen eines Substrats, wobei die genannte Sol-Gel-Lösung nach einem Verfahren erhalten wird, das aufeinanderfolgend die folgenden verfahrensstufen umfaßt:
a) Herstellen einer Sol-Gel-Lösung, indem ein molekularer Blei-Vorläufer, ein molekularer Titanvorläufer, ein molekularer Zirkonvorläufer und ein molekularer Vorläufer eines Lanthanidenmetalls mit einem Milieu in Kontakt gebracht wird, das eine Diol-Verbindung als Lösungsmittel und gegebenenfalls einen aliphatischen Monoalkohol umfaßt;
b) ruhen lassen der gemäß a) erhaltenen Lösung über eine zum Erhalt einer eine im wesentlichen konstante Viskosität aufweisenden Lösung erforderliche Zeitdauer, wobei diese Zeitdauer von einer Woche bis zu vier Monaten gestaffelt sein kann;
c) Verdünnen der gemäß b) erhaltenen Lösung in einem vorgegebenen Grad bzw. Verhältnis mit einerm Diol-haltigen Lösungsmittel gleicher Art wie das Lösungsmittel in der Verfahrensstufe a), oder mit einem Lösungsmittel, das mit dem in der Verfahrensstufe a) verwendeten Diol-haltigen Lösungsmittel mischbar ist,
e) eine Verfahrensstufe einer Wärmebehandlung der genannten Schicht hinsichtlich der Umwandlung in die Oxydkeramik, wobei diese Wärmebehandlung umfaßt:
° für jede der (n-1) ersten abgeschiedenen Schichten einen Zyklus von Verfahrensschritten, die aufeinander folgend umfassen.
- eine Verfahrensstufe der Trocknung jeder abgeschiedenen Schicht ;
- eine Verfahrensstufe der Calcinierung der genannten Schicht ;
- gegebenenfalls eine Verfahrensstufe des Vorglühens bzw. -anlassens der genannten Schicht;
° für die n-te abgeschiedene Schicht einen Zyklus von Verfahrenssctufen, der aufeinanderfolgend umfaßt:
° eine Verfahrensstufe der Trocknung der genannten Schicht;
° eine Verfahrensstufe der Calcinierung der genannten Schicht, sowie
° eine Verfahrensstufe des Vorglühens bzw. -anlassens der genannten Schicht; wobei die genannte Wärmebehandlung mit einer Verfahrensstufe des Glühens bzw. Anlassens der Gesamtheit der abgeschiedenen Schichten (d.h. der n-Schichten) abgeschlossen wird.

2. Verfahren nach Anspruch 1, bei welchem der genannte Blei-Vorläufer unter den anorganischen Bleisalzen, den organometallischen Bleiverbindungern gewählt wird.

3. Verfahren nach Anspruch 2, bei welchem das anorganische Bleisalz unter bleichlorid, Bleinitrat gewählt wird.

4. Verfahren nach Anspruch 2, bei welchem die organometallische Bleiverbindung unter Bleiazetat, den Bleialkoxyden gewählt wird.

5. Verfahren nach einem beliebigen der vorhergehenden Ansprüche, bei welchem der molekulare Vorläufer des Lanthanidenmetalls ein molekularer Lanthan-Vorläufer ist.

6. Verfahren nach Anspruch 5 , bei welchem der molekulare Lanthan-Vorläufer eine organometallische Lanthanverbindung ist.

7. Verfahren nach Anspruch 6, bei welchem die organometallische Lanthanverbindung Lanthanazetat ist.

8. Verfahren nach Anspruch 5, bei welchem der molekulare Lanthanvorläufer ein anorganisches Lanthansalz ist.

9. Verfahren nach Anspruch 8, bei welchem das anorganische Lanthansalz unter Lanthannitrat, Lanthanchlorid gewählt wird.

10. Verfahren nach einem beliebigen der vorhergehenden Ansprüche, bei welchem der molekulare Titanvorläufer eine organometallische Titanverbindung ist.

11. Verfahren nach Anspruch 10, bei welchem die organometallische Titanverbindung ein Titan-alkoxyd ist.

12. Verfahren nach einem beliebigen der vorhergehenden Ansprüche, bei welchem der molekulare Zirkonvorläufer eine organometallische Zirkonverbindung ist.

13. Verfahren nach Anspruch 12, bei welchem die organometallische Zirkonverbindung ein Zirkonalkoxyd ist.

14. Verfahren nach einem beliebigen der Ansprüche 1 bis 13, bei welchem das in der Verfahrensstufe a) und gegebenenfalls Verfahrensstufe c) verwendete Diol-haltige Lösungsmittel ein Alkylenglykol mit 2 bis 5 Kohlenstoffatomen ist.

15. Verfahren nach Anspruch 14, bei welchem das Diol-haltige Lösungsmittel Äthylenglykol ist.

16. Verfahren nach einem beliebigen der Ansprüche 1 bis 15, bei welchem der aliphatische Monoalkohol 1 bis 6 Kohlenstoffatome umfaßt.

17. Verfahren nach einem beliebigen der Ansprüche 1 bis 16, bei welchem, wenn das Lanthanidenmetall Lanthan ist, die Verfahrensstufe a) umfaßt:
- Herstellen einer ersten Lösung, indem in einem ein Diol-haltiges Lösungsmittel enthaltenden organischen Milieu ein molekularer Blei-Vorläufer und ein molekularer Zirkonvorläufer gelöst werden;
- Herstellen einer zweiten Lösung, indem ein molekularer Titanvorläufer und ein molekularer Zirkonvorläufer in einem organischen Milieu gelöst werden, das einen aliphatischen Monoalkohol und gegebenenfalls ein Diol-haltiges Lösungsmittel von gleicher Art wie das in der vorhergehenden Verfahrensstufe verwendete umfasst;
- Mischen der genannten ersten und der genannten zweiten Lösung, gegebenenfalls unter Heizung im Rückfluß.

18. Verfahren nach einem beliebigen der vorhergehenden Ansprüche, bei welchem das in der Verfahrensstufe c) verwendtete Lösungsmittel ein aliphatischer Monoalkohol ist.

19. Herstellungsverfahren nach Anspruch 1, bei welchem die Verfahrensstufe d) der Abscheidung im Wege des Eintauch-Abtropf-Verfahrens ('dip coating') erfolgt.

20. Herstellungsverfahren nach Anspruch 1 bei welchem die Verfahrensstufe der Abscheidung d) mittels Zentrifugalschleudern ('spin coating') erfolgt.

21. Herstellungsverfahren nach einem beliebigen der Ansprüche 1 bis 20, bei welchem das Substrat eine Siliziumtranche ist.

22. Herstellungsverfahren nach einem beliebigen der Ansprüche 1 bis 21, bei welchem die genannte(n) Substratoberfläche(n) vor der Verfahrensstufe d) mit einer Sperrschicht überzogen werden, welche ein unter den metallischen Oxyden mit Perovskit-Struktur gewähltes Material aufweist.

23. Herstellungsverfahren nach Anspruch 22, bei welchem die Sperrschicht aus einem unter PbTi O₃, SrTiO₃ gewählten Material besteht.

24. Herstellungsverfahren nach Anspruch 23, bei welchem die Sperrschicht aus PbTiO₃ besteht.

25. Herstellungsverfahren nach Anspruch 24, bei welchem die Sperrschicht nach einem Verfahren hergestellt wird, das aufeinanderfolgend die folgenden Verfahrensstufen umfaßt:
- Abscheiden wenigstens einer Schicht aus einer Sol-Gel-Vorläuferlösung von PbTiO₃ auf der bzw. den genannten Substratoberfläche(n);
- Wärmebehandlung der genannten Schicht hinsichtlich der Umwandlung der genannten Sol-Gel-Lösung in PbTiO₃.

26. Herstellungsverfahren nach Anspruch 25, bei welchem die Sol-Gel-Lösung als PbTiO₃-Vorläufer nach einem Verfahren hergestellt wird, das die folgenden Verfahrensstufen umfasst:
- Herstellen einer Sol-Gel-Lösung, indem ein molekularer Blei-Vorläufer, ein molekularer Titanvorläufer mit einem Milieu in Kontakt gebracht wird, das ein Diol-haltiges Lösungsmittel und gegebenenfalls einen aliphatischen Monoalkohol umfaßt;
- ruhen lassen der gemäß der vorstehenden Verfahrensstufe erhaltenen Lösung über eine zum Erhalt einer eine im wesentlichen konstante Viskosität aufweisenden Lösung erdorderliche Zeitdauer;
- Verdünnen der gemäß der vorstehenden Verfahrensstufe erhaltenen Lösung in einem vorgegebenen Grad bzw. Verhältnis mit einer Diol-haltigen Lösungsmittel gleicher Art wie das Lösungsmittel in der ersten Verfahrensstufe oder mit einem Lösungsmittel, das mit dem in der ersten Verfahrensstufe verwendeten Diol-haltigen Lösungsmittel mischbar ist.

27. Herstellungsverfahren nach Anspruch 1, bei welchem die Verfahrensstufe der Trocknung darin besteht, die Schicht nach der Abscheidung bei einer Temperatur unterhalb 100°C während einer Zeitdauer von 1 Minute bis 10 Minuten ruhen zu lassen.

28. Herstellungsverfahren nach Anspruch 1, bei welcher die Verfahrensstufe der Calcinierung bei einer Temperatur von 300 °C bis 380 ° C während einer Zeitdauer von 30 Sekunden bis 20 Minuten vorgenommen wird.

29. Herstellungsverfahren nach Anspruch 1, bei welchem die Verfahrensstufe des Glühens bzw. Anlassens bei einer Temperatur im Bereich von 500 °C bis 800 °C während einer Zeitdauer von 30 Sekunden bis 1 Stunde ausgeführt wird.

30. Herstellungsverfahren nach Anspruch 29, bei welchem die Verfahrensstufe des Vorglühens bzw. -anlassens bei einer Temperatur über 380 °C, die sich bis 450 °C erstrecken kann und vorzugsweise im Bereich zwischen 385 °C und 405 °C liegt, während einer Zeitdauer von 1 Minute bis zu 60 Minuten vorgenommen wird.
